# EUROPEAN PATENT SPECIFICATION

(11) **EP 1 401 247 B1**
(45) Date of publication and mention of the grant of the patent: **16.03.2016**
(21) Application number: 03021266.6
(22) Date of filing: 19.09.2003
(51) Int. Cl.: H05F 3/04

(54) **Method and apparatus for offset voltage control in bipolar ionization systems**
Verfahren und Vorrichtung zur Regelung der Offsetspannung in Bipolarenionisationssystemen
Procédé et dispositif pour le contrôle de la tension de décalage dans systèmes d'ionisation bipolaire

(30) Priority: 20.09.2002 US 412237 P; 11.09.2003 US 660001
(43) Date of publication of application: 24.03.2004
(73) Proprietor: Illinois Tool Works, Inc., Illinois 60025 (US)
(72) Inventor: Gorczyca, John, Lansdale Pennsylvania 19446 (US); Reagan, David D., Wilmington Delaware 19810 (US)
(74) Representative: Trinks, Ole

(56) References cited:
- EP-A- 1 067 828
- US-A- 4 477 263
- US-A- 4 757 421

## Description

### BACKGROUND OF THE INVENTION

The present invention relates generally to methods of controlling bipolar ionization systems and, more particularly, to a method of offset voltage control for bipolar pulse mode ionization systems.

Air ionization is the most effective method of eliminating static charges on nonconductive materials and isolated conductors. Air ionizers generate large quantities of positive and negative ions in the surrounding atmosphere which serve as mobile carriers of charge in the air. As ions flow through the air, they are attracted to oppositely charged particles and surfaces. Neutralization of electrostatically charged surfaces can be rapidly achieved through the process.

Air ionization may he performed using electrical ionizers which generate ions in a process known as corona discharge. Electrical ionizers generate air ions through this process by intensifying an electric field around a sharp point until it overcomes the dielectric strength of the surrounding air. Negative corona occurs when electrons are flowing from the electrode into the surrounding air. Positive corona occurs as a result of the flow of electrons from the air molecules into the electrode.

To achieve the maximum possible reduction in static charges from an ionizer of a given output, the ionizer must produce equal amounts of positive and negative ions. That is, the output of the ionizer must be "balanced." If the ionizer is out of balance, the isolated conductor and insulators can become charged such that the ionizer creates more problems than it solves. Ionizers may become imbalanced due to power supply drift, power supply failure of one polarity, contamination of electrodes, or degradation of electrodes. In addition, the output of an ionizer may be balanced, but the total ion output may drop below its desired level due to system component degradation.

A charge plate monitor is typically used to calibrate and periodically measure the actual balance of an electrical ionizer, since the actual balance in the work space may be different from the balance detected by the ionizer's sensor. The charge plate monitor is also used to periodically measure static charge decay time. If the decay time is too slow or too fast, the ion output may be adjusted by increasing or decreasing the preset ion current value. This adjustment is typically performed by adjusting two trim potentiometers (one for positive ion generation and one for negative ion generation) or by adjusting a value stored in software that represents an ion current reference value. Periodic decay time measurements are necessary because actual ion output in the work space may not necessarily be the same as the expected ion output for the ion output current value set in the ionizer.

A room ionization system typically includes a plurality of electrical ionizers connected to a single controller. A conventional room ionization system may include a plurality of ceiling-mounted emitter modules (also, referred to as "pods") connected in a daisychain manner by signal lines to a master controller.

Traditionally, a sensor is used in conjunction with a room system or a mini environment ionizer bar to control the offset voltage generated by the ionization system steady state direct current (DC) operation. Steady state DC operation implies constant production of both polarities of ionization from independent positive and negative pins. In this case, the offset voltage is the voltage that would develop on an isolated conductor in the presence of the ionization system. A charge plate monitor is used to determine the offset voltage of the ionization system. Sensors used for this type of application attempt to have essentially infinite input impedances such that they accurately measure offset voltage for negative feedback control of offset voltage. Alternatively, the sensors sample the current produced by the ionizer. Generally, an end user is attempting to control offset voltage to within some threshold critical for the success of their particular process or processes.

Controlling the offset voltage in a given environment is becoming increasingly important. Many modern semiconductor devices/wafers and disk drive heads (giant magnetoresistive or GMR heads) and the like are susceptible to electrostatic discharge (ESD) at lower voltage potentials. For example, such devices may be damaged by voltages around 100V so controlling to 50V or below may be of interest to avoid product losses and malfunctions.

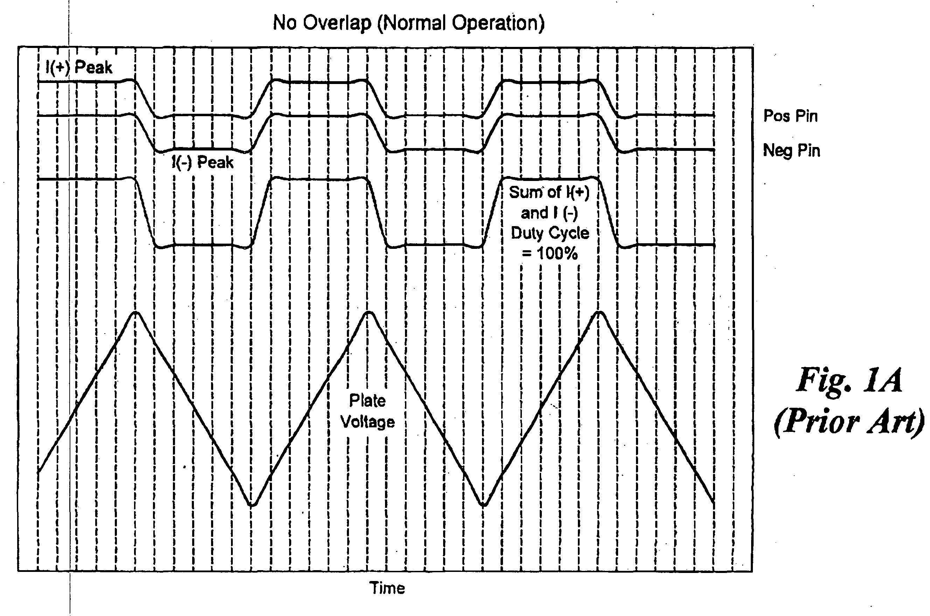

Pulsing systems offer good charge decay times, which are the measure of rate of charge neutralization, and are useful in environments with poor or inadequate airflow. However, most prior art pulsing systems do not attempt to limit offset voltage during pulse mode operation. As a result, pulse times and output levels must carefully be selected to achieve the desired charge decay time without producing excessive offset voltage swing levels. In one such prior art system shown in Fig. 1A, it is very difficult to use long pulse times as they will generate very large offset voltage swings. Offset voltage must be maintained within acceptable limits so that device damage does not occur. The objectionable offset voltage swings generated in a pulse mode system are such that during positive and negative pulses, only one polarity of ionization is provided. The resulting stream of ionization creates swings of offset voltages that can be measured on an isolated conductor. To limit the swing, the end user is forced to adjust the output of the pulse ionization system to a lower level, or select a pulse time that achieves the same result. In either case, charge decay times can become longer which is an undesirable side effect.

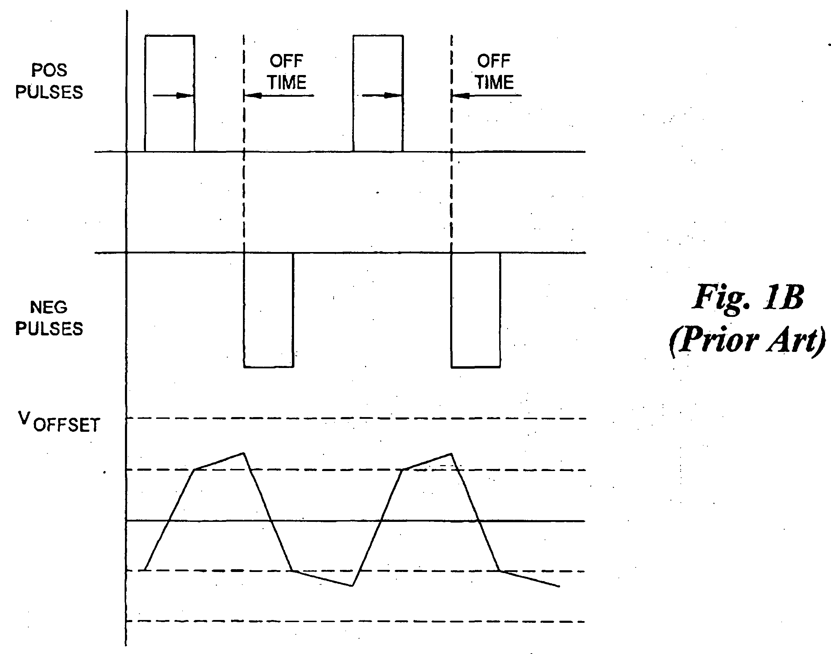

Fig. 1B shows that some prior art systems suggest using an "off-time" between pulses of alternate polarities to limit the offset voltage swing. In practice, this technique has several disadvantages. The high voltage power supplies used to provide ionization generally have long time constants associated with them that make a rapid shut down or a realized turn off difficult to attain. In the "off-time" technique, although the input to the high voltage supply is reduced, the output continues to produce ionization and, as a result, there is still a corresponding increase in offset voltage. Further, the duration of the "off-time" that the system uses also reduces the overall ion output of such a system that uses "off-time." Ultimately, ionization systems are installed to produce ions so this is an obvious drawback. Thus, the technique depicted in Fig. 1B has the inherent disadvantage of producing a lower overall ion density in the environment.

Document US 4,477,263 discloses an apparatus and a method for neutralizing static electric charges in a manufacturing area. A pair of electrodes is provided, wherein a current generating means is adapted for supplying a positive DC voltage to one of the electrodes and a negative DC voltage to the other one of the electrodes. Each of the electrodes is adapted as an electrode for one of the two possible polarities.

A control unit is provided, which in turn comprises a manually operable power adjustment means. This power adjustment means allows for changing a relative percentage of positive and negative ions, i.e. a shift towards an excess of positive or negative ions, respectively, wherein the electrodes are continuously supplied with their respective voltage.

Document EP 1 067 828 A1 discloses an ionizer provided with a pair of electrodes. A positive and a negative high voltage power supply connected to the electrodes is switched between a high state and a low state. An ion balance center is provided, wherein the output voltage value of this ion balance sensor is compared with a desired value. The outcome of this comparison is used to control the two switchable high voltage power supplies. In the disclosure of EP 1 067 828 A1, the positive polarity high voltage DC power supply is switched whilst the negative polarity high voltage DC power supply is constantly driven. Alternatively, the negative polarity high voltage DC power supply is switched whilst the positive polarity high voltage DC power supply is constantly driven. Alternatively, the positive high voltage DC power supply is switched on whenever the negative high voltage DC power supply is switched off, and vice versa.

Document US 4,757,421 discloses an ionization system equipped with a pair of electrodes. The electrodes are alternately provided with positive DC power and negative DC power. In the disclosure according to US 4,757,421, the switching occurs simultaneously and synchronized 180° out of phase, wherein both electrodes are adapted to generate both types of ions in an alternating fashion. During the operation of the conventional ionization system, the power supply to none of the electrodes is interrupted at any time, i.e. each of the electrodes is constantly generating ions.

What is needed, but not provided by the prior art ionization systems, is a method of controlling the offset voltage generated in pulse mode ionization within user designated limits while having charge decay times that are still adequate or better than adequate. Further, what is needed, but not provided by the prior art ionization systems, is a method of controlling a continuous ionization system in conjunction with a sensor by tracking the sensor alternately for positive and negative setpoints.

### BRIEF SUMMARY OF THE INVENTION

Briefly stated, the present system comprises a method of offset voltage control for pulse mode ionization systems, wherein the ionization system has positive and negative power supplies. The method includes controlling the overlap of the outputs of the positive and negative power supplies and determining an overlap that achieves a desired offset voltage. The method also includes storing the offset voltage and the corresponding overlap in memory. The method also includes controlling the duty cycle of the outputs of the positive and negative power supplies to achieve the desired offset voltage based upon the stored offset voltage comparison.

The present invention also comprises a bipolar ionization apparatus that includes a positive high voltage power supply having an output with at least one positive ion emitting electrode connected thereto and configured to generate positive ions and a negative high voltage power supply having an output with at least one negative ion emitting electrode connected thereto and configured to generate negative ions. The bipolar ionization apparatus further includes a controller that is configured to control a duty cycle of the outputs of the positive and negative high voltage power supplies to achieve a desired offset voltage by causing the outputs of the positive and negative high voltage power supplies to overlap by a selected amount of time in excess of zero.

### BRIEF DESCRIPTION OF THE SEVERAL VIEWS OF THE DRAWINGS

The foregoing summary, as well as the following detailed description of preferred embodiments of the invention, will be better understood when read in conjunction with the appended drawings. For the purpose of illustrating the invention, there are shown in the drawings embodiments which arc presently preferred. It should be understood, however, that the invention is not limited to the precise arrangements and instrumentalities shown.

In the drawings:
Fig. 1A is a graph of ion generation vs. time vs. controlled pulse mode voltage offset volts of a prior art pulse mode ionization system;
Fig. 1B is a graph and timing chart demonstrating a resultant voltage offset of an off-time type prior art pulse mode ionization system;
Fig. 2 is a graph of ion generation versus time versus controlled pulse mode voltage offset volts in accordance with a first preferred embodiment of the present invention;
Fig. 3 is a graph showing ion generation versus time versus controlled pulse mode voltage offset volts in accordance with the second preferred embodiment of the present invention;
Fig. 4 is a graph showing ion generation versus time versus controlled pulse mode voltage offset volts in accordance with the third preferred embodiment of the present invention;
Fig. 5 is a graph showing ion generation versus time versus controlled pulse mode voltage offset volts in accordance with the fourth preferred embodiment of the present invention;
Fig. 6A is a graph comparing voltage swing at a charge plate monitor versus percent overlap for various pulse times in accordance with the present invention;
Fig. 6B is a graph comparing percent overlap for a 50V swing versus ion current;
Fig. 7 is a graph demonstrating timing diagrams of duty cycles and calculations in accordance with the preferred embodiments of the present invention; and
Fig. 8 is a schematic diagram of a generic bipolar ionization system in which the present invention may be applied.

### DETAILED DESCRIPTION OF THE INVENTION

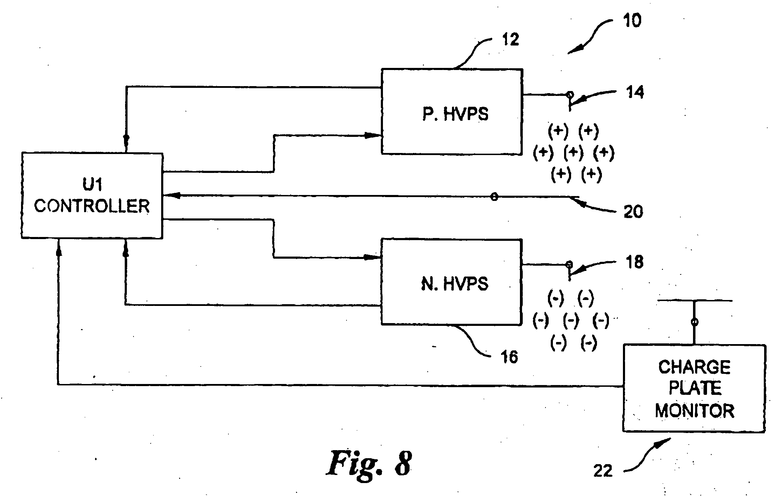

In the drawings, like numerals are used to indicate like elements throughout. Referring the drawings in detail, Fig. 8 shows a schematic diagram of a generic bipolar or dual polarity ionization system 10 in which the present invention may be applied. The ionization system 10 includes a controller U1, a first or positive high voltage power supply (P.HVPS) 12 having an output with at least one positive electrode 14 connected thereto and configured to generate positive ions, and a second or negative high voltage power supply (N.HVPS) 16 having an output with at least one negative electrode 18 connected thereto and configured to generate negative ions. The controller U1 controls the P.HVPS 12 and N.HVPS 16 in a pulsed mode, alternating the P.HVPS 12 and N.HVPS 16 in an on/off fashion. The controller U1 is configured to control the outputs of the positive and negative high voltage power supplies P.HVPS 12 and N.HVPS 16 to achieve a desired offset voltage by causing the outputs of the positive and negative high voltage power supplies P.HVPS 12 and N.HVPS 16 to overlap by a selected amount of time in excess of zero. The feedback may be in the form of a measured return current from each respective supply, i.e., the P.HVPS 12 and N.HVPS 16, or from a common sensor 20.

In prior art systems, the controller U1 would turn the P.HVPS 12 on while keeping the N.HVPS 16 off, and then switch the P.HVPS 12 off and turn the N.HVPS 16 on, in an alternating fashion with little or no overlap, as depicted in the graph of Fig. 1A. Fig. 1A is a graph of ion generation vs. time and control pulse mode (CPM) voltage offset (Voffset) in volts vs. time. Fig. 1A demonstrates that the CPM Voffset swings are relatively significant.

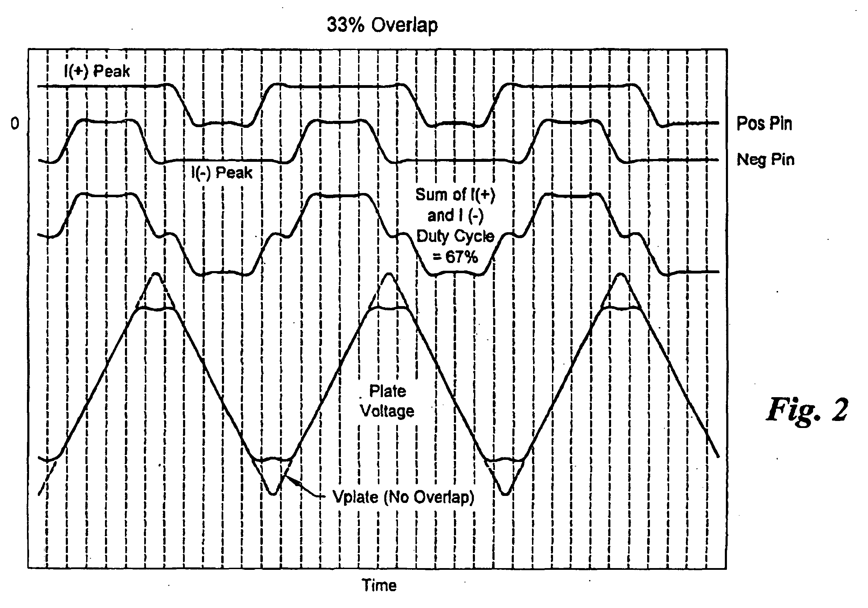

Fig. 2 is a graph of ion generation versus time and CPM Voffset in volts versus time, in accordance with a first preferred embodiment of the present invention. By controlling the overlap of outputs of the P.HVPS 12 and N.HVPS 16, the offset voltage can be maintained within user specifications or user setpoints and charge decay times are improved. The method also includes determining the overlap of the outputs of the P.HVPS 12 and N.HVPS 16 that achieves a desired offset voltage and storing the offset voltage and the corresponding overlap in memory. The method further includes controlling the duty cycle of the outputs of the P.HVPS 12 and N.HVPS 16 to achieve the desired offset voltage based upon the stored offset voltage comparison.

The present invention also includes controlling the overlap based upon an algorithm that uses the comparison of the actual voltage potential to the desired offset voltage.

The actual voltage potential in an area surrounding the ionizer system 10 is measured using a sensor 20 and the actual voltage potential is then compared to a user desired offset voltage. The comparison of the actual to the desired offset voltage is used with an algorithm such as time proportioning, proportional/integral/derivative (PID), PI, P, error proportioning and the like, in order to control the overlap.

Pulses of opposite polarity are overlapped as shown in Fig. 2. In the example shown in Fig. 2, the pulses are overlapped by about 33%, thereby having a resultant offset voltage which is less than the prior art system shown in Fig. 1A. Charge delivery from the ionization system can be adjusted so that the offset voltage as measured by a charge plate monitor 22 (Fig. 8) is limited. The offset voltage in CPM is basically the integral of the ion current. Fig. 2 demonstrates that the overlapping of the pulses of opposite polarity results in a zero ("0") integral for the duration of the overlap. As a result, the offset voltage is held steady during the overlap and can be limited to levels deemed acceptable by the end user. Holding the offset voltage steady and at an acceptable level makes it possible to achieve charge decay times not possible with prior art systems such as the one shown in Fig. 1A.

As mentioned above, various offset voltages as measured by the charge plate monitor 22 can be achieved by varying the percentage overlap or duration of the overlap. The second through fourth preferred embodiments demonstrate other variations of the percentage overlap as compared to the first preferred embodiment.

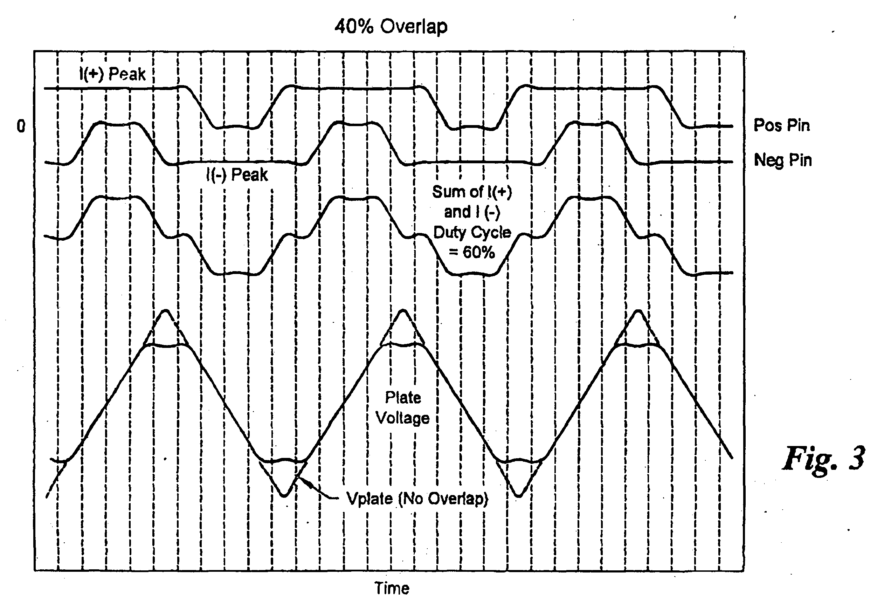

Fig. 3 is a graph of ion generation versus time versus CPM Voffset in volts in accordance with a second preferred embodiment of the present invention. In the second preferred embodiment, pulses of opposite polarity are overlapped by about 40% thereby having a resultant offset voltage which is less than with the first preferred embodiment.

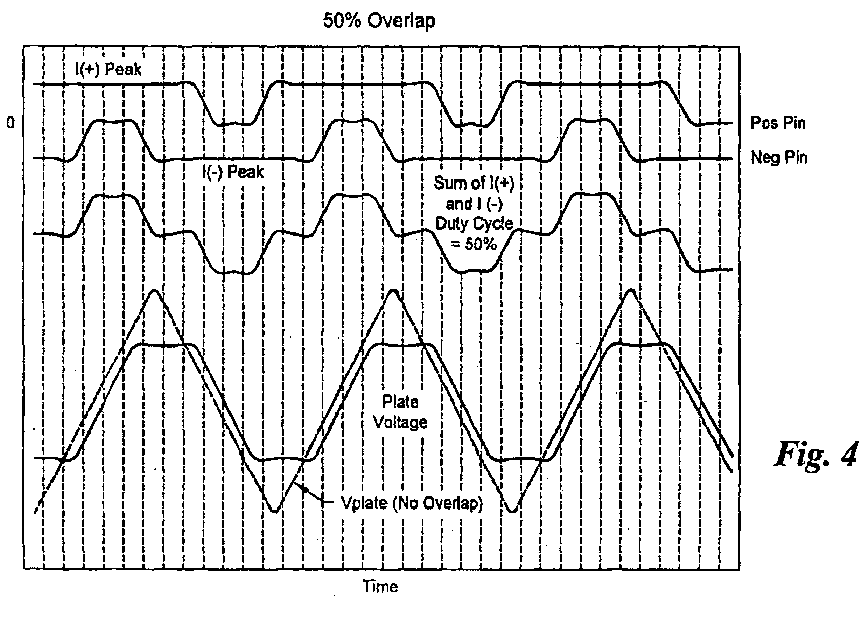

Fig. 4 is a graph of ion generation versus time versus CPM Voffset in volts in accordance with a third preferred embodiment of the present invention. In the third preferred embodiment, pulses of opposite polarity are overlapped by about 50% thereby having a resultant offset voltage which is less than with the second preferred embodiment.

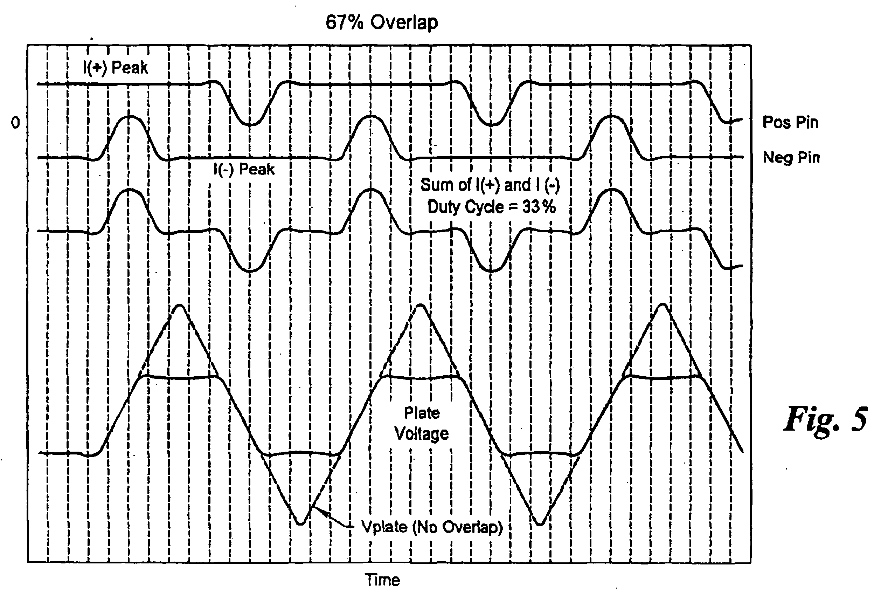

Fig. 5 is a graph of ion generation versus time versus CPM Voffset in volts in accordance with a fourth preferred embodiment of the present invention. In the fourth preferred embodiment, pulses of opposite polarity are overlapped by about 67% thereby having a resultant offset voltage which is less than with the third preferred embodiment.

Other embodiments employing the method of offset voltage control can be used with varying amounts of overlap expressed in either time or percentage without departing from the broad inventive scope herein. Further, the overlap can also be controlled so as to result in a square wave when associated current amplitudes of the power supplies are fixed. Furthermore, the overlap can also be controlled so as to result in one of a sine wave, a square wave, a saw tooth wave and a clipped wave when the amplitudes are variable.

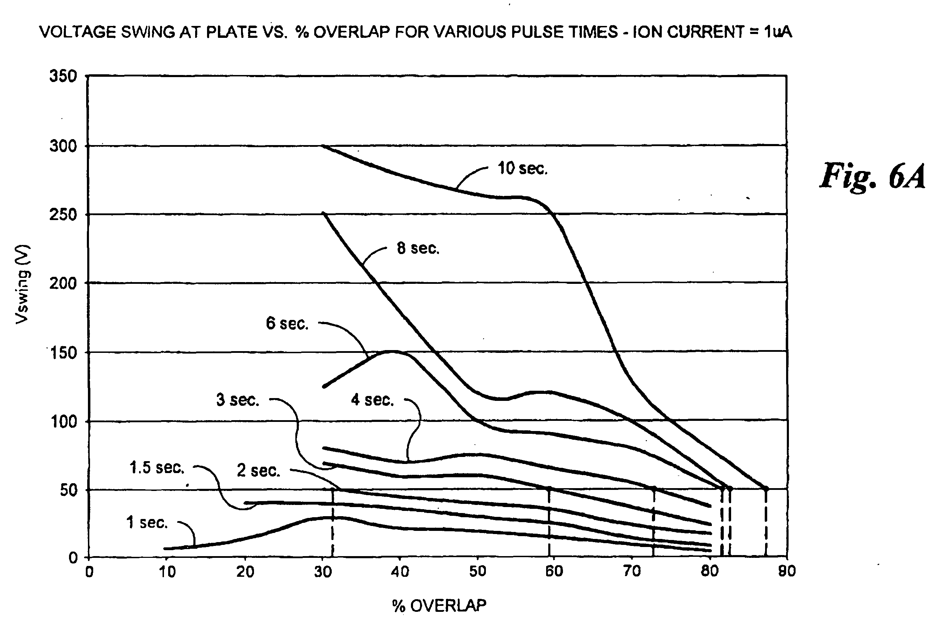

Fig. 6A is a graph comparing voltage swing at a charge plate monitor 22 versus percent overlap for various pulse times in accordance with the present invention. As shown, a longer pulse time (e.g., 10 seconds) requires a correspondingly longer or increased amount of overlap to control the offset voltage swing. A relatively shorter pulse time (e.g., less than 1 second) may not require any overlap to maintain a low offset voltage swing:

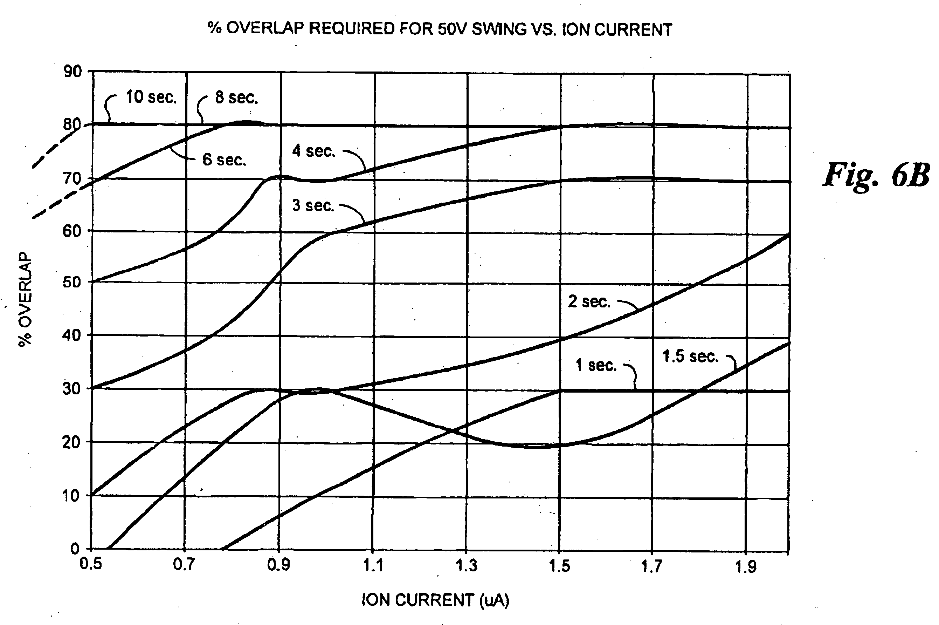

Fig. 6B is a graph comparing percent overlap for a 50V swing versus ion current. As shown, in order to maintain a particular offset voltage limit, in this case 50V, as the ion current is increased a corresponding increase in the percentage of on-time overlap must occur. The relationship between ion current and increase in percentage overlap is non-linear and varies for given pulse times.

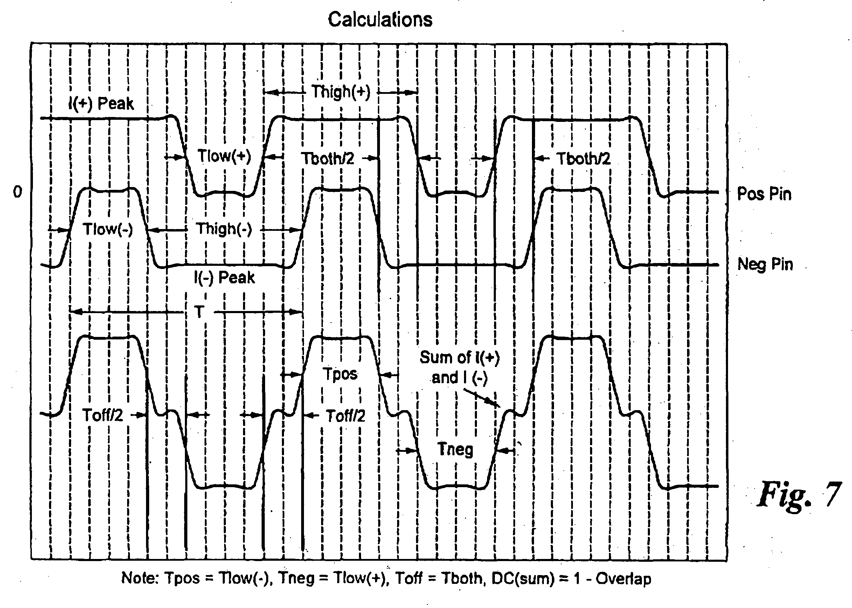

Fig. 7 includes timing diagrams of duty cycles in accordance with preferred embodiments of the present invention. As used herein, the percentage overlap refers to the percentage of time that both power supplies are turned on (T_{both}) compared to the total time for a cycle (Tₜₒₜ). For our purposes duty cycle is defined as the time during which the wave is non-zero divided by the total period, T. One can ascertain the percentage of the on time wherein the overlap occurs by a similar calculation. But, the more critical information is the percentage overlap for the total cycle time because increasing the percentage overlap to reduce offset voltage is not intended to change the overall cycle time Tₜₒₜ.

Another control approach that obtains a similar net result (amount of overlap) is to not turn off the first polarity power supply, either P.HVPS 12 or N.HVPS 16, when the other polarity power supply is turned on for a period of about (T_{both}/2). The first polarity in question is then kept in the off state or low state for a period of T_{Low} (low time) before being turned on again. It is contemplated that the only data that is then required to be stored in memory is T_{Low} and Tₜₒₜ and other values can be calculated therefrom. In this contemplated embodiment, the duty cycle is dependent on the percent overlap of the HVPS 12 and N.HVPS 16. Of course other mathematical or control logic implementations may be utilized without departing from the broad inventive scope of the present invention.

By using the present method of pulse mode control, existing controller-based ionization systems 10 can be updated by downloading to or replacing firmware which controls or supplies a controlling program to the system controller U1. It is contemplated that the present method could be used in other circuits not having controllers by allowing adjustability in the individual power supply control circuits to thereby provide overlapping of the outputs.

In an example not part of the present invention, both P.UVPS and N.HVPS 12, 16 can be run continuously, i.e., in a steady state DC operation generating a constant supply of both positive and negative ions, in conjunction with the common feedback sensor 20 which is able to track a positive and negative setpoint in an alternating fashion such that a pulsing effect or quasi-pulsing effect is achieved even though both power supplies 12, 16 never shut off. In this case, however, waves of ionization provide both polarities of ionization with a fixed bias of alternating positive and negative content. For example, when the sensor 20 is tracking a positive setpoint, the ionization is biased positive to provide more positive ions to reach the predetermined level, so the positive power supply 12 would likely ramp up and the negative power supply 16 would likely ramp down to try to attain the positive setpoint. Similarly, when the sensor is tracking the negative setpoint, the ionization is biased negative to provide more negative ions to reach the predetermined level, so the positive power supply 12 would likely ramp down and the negative power supply 16 would likely ramp up to try to attain the negative setpoint. In the fifth preferred embodiment, the positive and negative setpoints of the sensor 20 are chosen or calibrated to avoid exceeding a predetermined level as specified by the user, for example +50 V (positive setpoint) and -50V (negative setpoint). The sensor 20 may measure ion current to determine the corresponding offset voltage or may be a charge plate monitor or balance sensor which directly measures offset voltage to use as a process variable.

In effect, this example, which is not a part of the present invention, is a dual setpoint, dual output controller that alternates between the two setpoints based on a cycle time. The first setpoint (e.g., the positive setpoint) is selected for a predetermined period of time and the control algorithm tries to reach the first setpoint while measuring the sensor 20 using control techniques that arc known in the art such as PID, PI, P, time proportioning, error proportioning and the like. Similarly, the second setpoint (e.g., the negative setpoint) is selected for a similar predetermined period of time and the control algorithm tries to reach the second setpoint while measuring the sensor 20 using similar control techniques. Of course other control techniques and algorithms may be utilized.

From the foregoing it can be seen that the present invention comprises a method of offset voltage control for pulse mode ionization systems using overlap of the positive and negative outputs to limit or control the offset voltage. It will be appreciated by those skilled in the art that changes could be made to the embodiments described above without departing from the broad inventive concept thereof.

## Claims

1. A bipolar ionization apparatus comprising:
- a positive high voltage power supply having an output with at least one positive ion emitting electrode connected thereto and configured to generate positive ions;
- a negative high voltage power supply having an output with at least one negative ion emitting electrode connected thereto and configured to generate negative ions; and
- a controller configured to control a duty cycle of the outputs of the positive and negative high voltage power supplies to achieve a desired offset voltage by causing the outputs of the positive and negative high voltage power supplies to overlap by a selected amount of time in excess of zero,
wherein overlapping is defined as a time period that both the positive and the negative high voltage power supplies are turned on compared to the total time for one cycle of power supply,
and wherein the positive and the negative high voltage power supplies are alternated in an ON/OFF fashion.

2. The bipolar ionization apparatus according to claim 1, wherein control of the outputs of the positive and negative high voltage power supplies is modified using pulse duration modulation to obtain a user desired shape of an output wave.

3. The bipolar ionization apparatus according to claim 1, wherein the overlap results in a square wave when associated current amplitudes of the power supplies are fixed.

4. The bipolar ionization apparatus according to claim 1, wherein the overlap results in one of a sine wave, a square wave, a saw tooth wave and a clipped wave when the amplitudes are variable.

5. The bipolar ionization apparatus according to claim 1, wherein the desired offset voltage is adjustable by a user.

6. A method of controlling an offset voltage of an ionization system, the ionization system including positive and negative high voltage power supplies, each of the power supplies having a respective output with at least one ion emitting electrode connected thereto for generating ions, the method comprising:
- controlling a duty cycle of the outputs of the positive and negative high voltage power supplies to achieve a desired offset voltage by causing the outputs of the positive and negative high voltage power supplies to overlap by a selected amount of time in excess of zero,
wherein overlapping is defined as a time period that both the positive and the negative high voltage power supplies are turned on compared to the total time for one cycle of power supply,
and wherein the positive and the negative high voltage power supplies are alternated in an ON/OFF fashion.

7. The method according to claim 6, wherein the duty cycle is modified using pulse duration modulation to achieve a user desired shape of the output wave.

8. The method according to claim 6, the overlap results in a square wave when associated current amplitudes of the power supplies are fixed.

9. The method according to claim 6, wherein the overlap results in one of a sine wave, a square wave, a saw tooth wave and clipped wave when the amplitudes are variable.

10. The method according to claim 6, further comprising the steps of:
- determining a particular overlap of the outputs of the positive and negative high voltage power supplies that achieves a particular offset voltage;
- storing the particular offset voltage and the corresponding particular overlap in memory; and
- controlling the duty cycle and the overlap based upon the stored offset voltage and the stored corresponding overlap when the desired offset voltage is approximately equal to the stored offset voltage.

11. The method according to claim 6, further comprising the steps of:
- measuring an actual voltage potential in an area surrounding the ionizer;
- comparing the actual voltage potential to the desired offset voltage; and
- controlling the overlap based upon an algorithm that uses the comparison of the actual voltage potential to the desired offset voltage.

## Patentansprüche

1. Vorrichtung zur bipolaren Ionisation, umfassend:
- eine positive Hochspannungsversorgung, die einen Ausgang mit wenigstens einer damit verbundenen Elektrode aufweist, die positive Ionen freisetzt, und die dafür ausgelegt ist, positive Ionen zu erzeugen;
- eine negative Hochspannungsversorgung, die einen Ausgang mit wenigstens einer damit verbundenen Elektrode aufweist, die negative Ionen freisetzt, und die dafür ausgelegt ist, negative Ionen zu erzeugen; und
- eine Regeleinheit, die dafür ausgelegt ist, einen Arbeitszyklus der Ausgänge der positiven und der negativen Hochspannungsversorgung zu regeln, um eine gewünschte Offsetspannung zu erreichen, indem eine Überlappung der Ausgänge der positiven und der negativen Hochspannungsversorgung um eine ausgewählte Zeitspanne größer als null bewirkt wird,
wobei Überlappung als eine Zeitdauer, während der sowohl die positive als auch die negative Hochspannungsversorgung eingeschaltet sind, verglichen mit der Gesamtzeit eines Spannungsversorgungszyklus definiert ist,
und wobei die positive und die negative Hochspannungsversorgung nach dem EIN-/AUS-Prinzip alternieren.

2. Vorrichtung zur bipolaren Ionisation gemäß Anspruch 1, wobei die Regelung der Ausgänge der positiven und der negativen Hochspannungsversorgung mithilfe von Pulsdauermodulation modifiziert wird, um eine vom Benutzer gewünschte Ausgangswellenform zu erhalten.

3. Vorrichtung zur bipolaren Ionisation gemäß Anspruch 1, wobei die Überlappung in einer Rechteckwelle resultiert, wenn zugehörige Stromamplituden der Spannungsversorgungen fest sind.

4. Vorrichtung zur bipolaren Ionisation gemäß Anspruch 1, wobei die Überlappung in einem von einer Sinuswelle, einer Rechteckwelle, einer Sägezahnwelle und einer gekappten Welle resultiert, wenn die Amplituden variabel sind.

5. Vorrichtung zur bipolaren Ionisation gemäß Anspruch 1, wobei die gewünschte Offsetspannung von einem Benutzer einstellbar ist.

6. Verfahren zur Regelung einer Offsetspannung eines Ionisationssystems, wobei das Ionisationssystem eine positive und eine negative Hochspannungsversorgung aufweist, wobei jede der Spannungsversorgungen einen entsprechenden Ausgang mit wenigstens einer damit verbundenen Elektrode aufweist, die Ionen freisetzt, wobei das Verfahren umfasst:
- Regeln eines Arbeitszyklus der Ausgänge der positiven und der negativen Hochspannungsversorgung, um eine gewünschte Offsetspannung zu erreichen, indem eine Überlappung der Ausgänge der positiven und der negativen Hochspannungsversorgung um eine ausgewählte Zeitspanne größer als null bewirkt wird,
wobei Überlappung als eine Zeitdauer, während der sowohl die positive als auch die negative Hochspannungsversorgung eingeschaltet sind, verglichen mit der Gesamtzeit eines Spannungsversorgungszyklus definiert ist,
und wobei die positive und die negative Hochspannungsversorgung nach dem EIN-/AUS-Prinzip alternieren.

7. Verfahren gemäß Anspruch 6, wobei der Arbeitszyklus mithilfe von Pulsdauermodulation modifiziert wird, um eine vom Benutzer gewünschte Ausgangswellenform zu erreichen.

8. Verfahren gemäß Anspruch 6, wobei die Überlappung in einer Rechteckwelle resultiert, wenn zugehörige Stromamplituden der Spannungsversorgungen fest sind.

9. Verfahren gemäß Anspruch 6, wobei die Überlappung in einem von einer Sinuswelle, einer Rechteckwelle, einer Sägezahnwelle und einer gekappten Welle resultiert, wenn die Amplituden variabel sind.

10. Verfahren gemäß Anspruch 6, wobei das Verfahren ferner die Schritte umfasst:
- Bestimmen einer bestimmten Überlappung der Ausgänge der positiven und der negativen Hochspannungsversorgung, mit der eine bestimmte Offsetspannung erreicht wird;
- Ablegen der bestimmten Offsetspannung und der entsprechenden bestimmten Überlappung im Speicher; und
- Regeln des Arbeitszyklus und der Überlappung basierend auf der gespeicherten Offsetspannung und der gespeicherten entsprechenden Überlappung, wenn die gewünschte Offsetspannung ungefähr gleich der gespeicherten Offsetspannung ist.

11. Verfahren gemäß Anspruch 6, wobei das Verfahren ferner die Schritte umfasst:
- Messen eines tatsächlichen Spannungspotentials in einem Bereich, der den Ionisator umgibt;
- Vergleichen des tatsächlichen Spannungspotentials mit der gewünschten Offsetspannung; und
- Regeln der Überlappung basierend auf einem Algorithmus, der den Vergleich des tatsächlichen Spannungspotentials mit der gewünschten Offsetspannung verwendet.

## Revendications

1. Appareil d'ionisation bipolaire comprenant :
une alimentation haute tension positive ayant une sortie avec au moins une électrode émettant des ions positifs y étant connectée et configurée pour générer des ions positifs ;
une alimentation haute tension négative ayant une sortie avec au moins une électrode émettant des ions négatifs y étant connectée et configurée pour générer des ions négatifs ; et
un contrôleur configuré pour contrôler un facteur d'utilisation des sorties des alimentations haute tension positive et négative pour parvenir à une tension de décalage souhaitée en amenant les sorties des alimentations haute tension positive et négative à se chevaucher pendant une quantité sélectionnée de temps supérieure à zéro,
où le chevauchement est défini comme une période de temps pendant laquelle les deux alimentations haute tension positive et négative sont allumées par rapport au temps total d'un cycle d'alimentation,
et où les alimentations haute tension positive et négative sont alternées de manière ALLUMEES/ETEINTES.

2. Appareil d'ionisation bipolaire selon la revendication 1, dans lequel le contrôle des sorties des alimentations haute tension positive et négative est modifié au moyen d'une modulation de durée d'impulsion pour obtenir une forme souhaitée par un utilisateur de l'onde de sortie.

3. Appareil d'ionisation bipolaire selon la revendication 1, dans lequel le chevauchement conduit à une onde carrée lorsque des amplitudes de courant associées des alimentations sont fixées.

4. Appareil d'ionisation bipolaire selon la revendication 1, dans lequel le chevauchement conduit à une onde parmi une onde sinusoïdale, une onde carrée, une onde en dents de scie et une onde rognée lorsque les amplitudes sont variables.

5. Appareil d'ionisation bipolaire selon la revendication 1, dans lequel la tension de décalage souhaitée est réglable par un utilisateur.

6. Procédé de contrôle d'une tension de décalage d'un système d'ionisation, le système d'ionisation comprenant des alimentations haute tension positive et négative, chacune des alimentations ayant une sortie respective avec au moins une électrode émettant des ions y étant connectée pour générer des ions, le procédé comprenant les étapes suivantes :
contrôler un facteur d'utilisation des sorties des alimentations haute tension positive et négative pour parvenir à une tension de décalage souhaitée en amenant les sorties des alimentations haute tension positive et négative à se chevaucher pendant une quantité sélectionnée de temps supérieure à zéro,
où le chevauchement est défini comme une période de temps pendant laquelle les deux alimentations haute tension positive et négative sont allumées par rapport au temps total d'un cycle d'alimentation,
et où les alimentations haute tension positive et négative sont alternées de manière ALLUMEES/ETEINTES.

7. Procédé selon la revendication 6, dans lequel le facteur d'utilisation est modifié au moyen d'une modulation de durée d'impulsion pour obtenir une forme souhaitée par un utilisateur de l'onde de sortie.

8. Procédé selon la revendication 6, dans lequel le chevauchement conduit à une onde carrée lorsque des amplitudes de courant associées des alimentations sont fixées.

9. Procédé selon la revendication 6, dans lequel le chevauchement conduit à une onde parmi une onde sinusoïdale, une onde carrée, une onde en dents de scie et une onde rognée lorsque les amplitudes sont variables.

10. Procédé selon la revendication 6, comprenant en outre les étapes suivantes :
déterminer un chevauchement particulier des sorties des alimentations haute tension positive et négative qui permet d'obtenir une tension de décalage particulière ;
stocker la tension de décalage particulière et le chevauchement particulier correspondant en mémoire ; et
contrôler le facteur d'utilisation et le chevauchement sur la base de la tension de décalage stockée et du chevauchement correspondant stocké lorsque la tension de décalage souhaitée est approximativement égale à la tension de décalage stockée.

11. Procédé selon la revendication 6, comprenant en outre les étapes suivantes :
mesurer un potentiel de tension réel dans une zone entourant l'ioniseur ;
comparer le potentiel de tension réel à la tension de décalage souhaitée ; et
contrôler le chevauchement sur la base d'un algorithme qui utilise la comparaison d'un potentiel de tension réel à la tension de décalage souhaitée.
